(19) Europäisches Patentamt
European Patent Office
Office européen des brevets

(11) **EP 3 799 095 A1**

(12) **DEMANDE DE BREVET EUROPEEN**

(43) Date de publication:
**31.03.2021  Bulletin 2021/13**

(51) Int Cl.:
***H01H 11/00*** *(2006.01)*      *H01H 33/666* *(2006.01)*

(21) Numéro de dépôt: **20191082.5**

(22) Date de dépôt: **14.08.2020**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **25.09.2019  FR 1910562**

(71) Demandeur: **Schneider Electric Industries SAS 92500 Rueil Malmaison (FR)**

(72) Inventeurs:
• **ROSSI, Nicolas**
  **38360 Sassenage (FR)**
• **ALBERTO, Diego**
  **38700 Corenc (FR)**
• **BRUN, Philippe**
  **38190 Bernin (FR)**

(74) Mandataire: **Percheron, Arthur**
  **Schneider Electric Industries SAS**
  **Service Propriété Industrielle - Hive 4F**
  **35 rue Joseph Monier - CS30323**
  **92506 Rueil Malmaison Cedex (FR)**

(54) **DÉTERMINATION D'UN ÉTAT D'UN APPAREIL DE COUPURE**

(57)     Procédé de détection d'un état d'un appareil de coupure, l'appareil de coupure comprenant un élément mobile entre une première position et une seconde position.

FIG. 3

EP 3 799 095 A1

# EP 3 799 095 A1

## Description

## Domaine technique

La présente invention concerne un procédé de détection d'un état d'un appareil de coupure.
L'invention concerne également un appareil de coupure mettant en œuvre un tel procédé.

## Technique antérieure

Une ligne d'alimentation d'une charge électrique comprend classiquement au moins un appareil de coupure. L'appareil de coupure comprend un mécanisme d'actionnement de paires de contacts mobiles relativement l'un à l'autre afin d'interrompre ou rétablir si nécessaire le passage d'un courant électrique.
Un dysfonctionnement du mécanisme d'actionnement de l'appareil de coupure peut avoir des conséquences graves, par exemple du fait de l'apparition d'un arc électrique non désiré lors d'un mauvais déplacement des contacts entre eux.
Aussi, afin d'assurer une maintenance satisfaisante, il est actuellement nécessaire de vérifier les bonnes performances mécaniques et le bon fonctionnement d'un tel appareil de coupure à intervalles réguliers.
Toutefois, bien que pouvant être généralement satisfaisante, cette maintenance peut s'avérer insuffisante en ce qu'un problème peut survenir juste après qu'une vérification ait été effectuée, et peut donc être détecté trop tardivement uniquement lors de la prochaine opération de maintenance.
En outre, ces opérations de maintenance nécessitent un arrêt du fonctionnement de l'appareil de coupure, avec parfois un démontage/remontage long et fastidieux de certains éléments.
Enfin, ces opérations de maintenance ne permettent pas de différencier d'une part un dysfonctionnement potentiellement critique et grave de l'appareil de coupure, et d'autre part un dysfonctionnement relativement moins problématique, lié de façon générale à une usure ou un vieillissement graduel inhérents aux éléments de l'appareil de coupure mais permettant toujours à celui-ci de fonctionner.
Un des buts de l'invention est donc de proposer un procédé de détection de l'état de l'appareil de coupure simple, fiable et économique, qui permet d'assurer une maintenance et un diagnostic de son fonctionnement plus efficace.

## Résumé

L'invention vient améliorer la situation.
Il est proposé un procédé de détection d'un état d'un appareil de coupure, l'appareil de coupure comprenant un élément mobile entre une première position et une seconde position, le procédé comprenant les étapes suivantes, pour une itération d'indice k supérieur ou égal à 2 :

a) Acquérir au moins une mesure indicative d'un déplacement de l'élément mobile entre la première position et la seconde position à l'itération d'indice k ;

b) Comparer au moins la mesure acquise à l'itération donnée k avec un premier ensemble de mesures acquises lors des itérations précédentes 1 à k-1 ;

c) Générer une première alarme en fonction de la comparaison obtenue à l'étape b) pour indiquer que l'appareil de coupure est dans un état indisponible ;

d) Comparer au moins la mesure acquise à l'itération donnée k avec un second ensemble de mesures acquises lors des itérations précédentes 1 à k-1 ; et

e) Générer une seconde alarme en fonction de la comparaison obtenue à l'étape d) pour indiquer que l'appareil de coupure est dans un état dégradé.

De cette façon, on obtient un diagnostic de l'appareil de coupure représentatif de la situation réelle, et non simplement simulé, de l'état mécanique des éléments de l'appareil de coupure.
En outre, l'invention permet de discriminer entre un état indisponible nécessitant une maintenance urgente, et un état dégradé nécessitant uniquement une surveillance et une maintenance renforcées pour s'assurer du bon fonctionnement de l'appareil de coupure.
Les caractéristiques exposées dans les paragraphes suivants peuvent, optionnellement, être mises en œuvre. Elles peuvent être mises en œuvre indépendamment les unes des autres ou en combinaison les unes avec les autres :

2

Selon une réalisation, le premier ensemble comprend, avantageusement consiste en, les mesures acquises entre les itérations k-L et k-1, L étant un entier supérieur ou égal à 1.

Selon une autre réalisation, la comparaison obtenue à l'étape b) est effectuée par application du critère de Chauvenet.

Selon une autre réalisation, la comparaison obtenue à l'étape b) est effectuée selon la formule suivante :

[Math. 1]

$$D[k] = \frac{|X[k] - \bar{X}_L[k]|}{\sigma_L[k]}$$

$$\bar{X}_L[k] = \sum_{n=1}^{L} x[k-n] \Big/ L$$

$$\sigma_L[k] = \sqrt{\sum_{n=1}^{L}(x[k-n] - \bar{X}_L[k])^2 \Big/ L - 1}$$

Selon une autre réalisation, le second ensemble comprend, avantageusement consiste en, les mesures acquises entre les itérations N et N+M-1, N et M étant des entiers supérieurs ou égaux à 1.

Selon une autre réalisation, la comparaison obtenue à l'étape d) est effectuée selon la formule suivante :

[Math. 2]

$$R[k] = \frac{\bar{X}_M[k]}{\bar{X}_{M_{ref}}}$$

$$\bar{X}_M[k] = \sum_{n=0}^{M-1} x[k-n] \Big/ M$$

$$\bar{X}_{M_{ref}} = \sum_{n=N}^{N+M-1} x[n] \Big/ M$$

Selon une autre réalisation, la première alarme et/ou la seconde alarme sont générés lorsque les comparaisons obtenues à l'étape b) et/ou à l'étape d) sont supérieures à une valeur seuil.

Selon une autre réalisation, la mesure correspond à une plage de rotation comprise entre 20 % et 80 % d'une course de déplacement de l'élément mobile entre la première position et la seconde position.

Selon une autre réalisation, la mesure est égale à la durée du déplacement de l'élément mobile entre deux positions intermédiaires comprises entre la position ouverte et la position fermée.

Selon une autre réalisation, le procédé comprend une étape supplémentaire :

f) Mémoriser la mesure d'itération d'indice k acquise à l'étape a).

Selon une autre réalisation, la mesure acquise correspond à un passage en condition réelle d'un module de coupure entre une position ouverte et une position fermée.

Il est également proposé un appareil de coupure mettant en œuvre le procédé selon l'invention.

Selon une réalisation, l'élément mobile est un levier rotatif principal.

**Brève description des dessins**

D'autres caractéristiques, détails et avantages apparaîtront à la lecture de la description détaillée ci-après, et à l'analyse des dessins annexés, sur lesquels :

**Fig. 1**

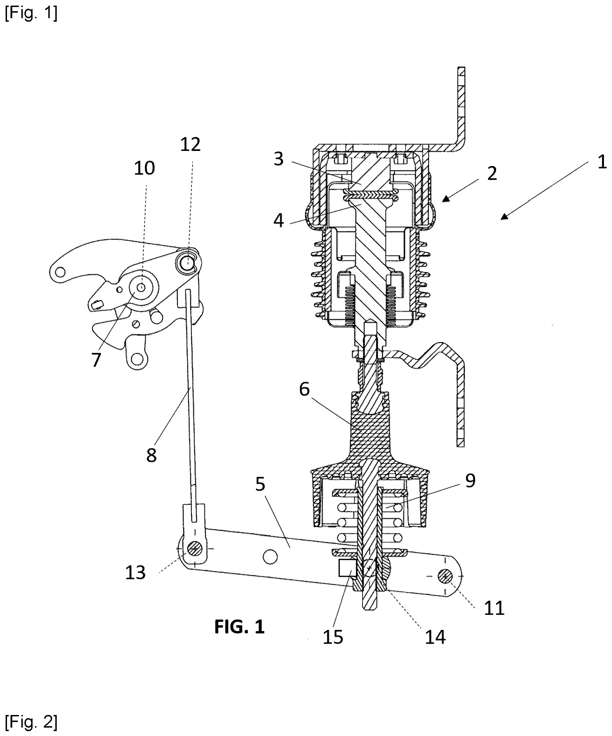

[Fig. 1] est une vue en coupe d'un exemple particulier d'un module d'un appareil de coupure susceptible de mettre en œuvre le procédé de détection selon l'invention.

**Fig. 2**

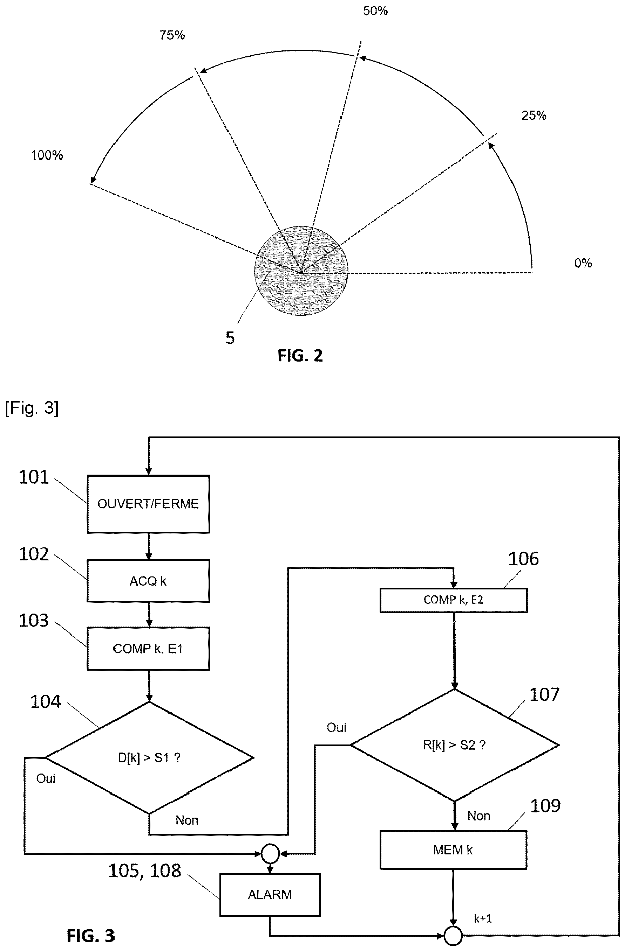

[Fig. 2] représente schématiquement une course de déplacement d'un élément mobile de l'appareil de coupure de la [Fig. 1] entre une première position, correspondant à 0% de la course de déplacement, et une seconde position, correspondant à 100% de la course de déplacement.

**Fig. 3**

[Fig. 3] est une représentation schématique d'un mode de réalisation du procédé de détection selon l'invention.

**Fig. 4A**

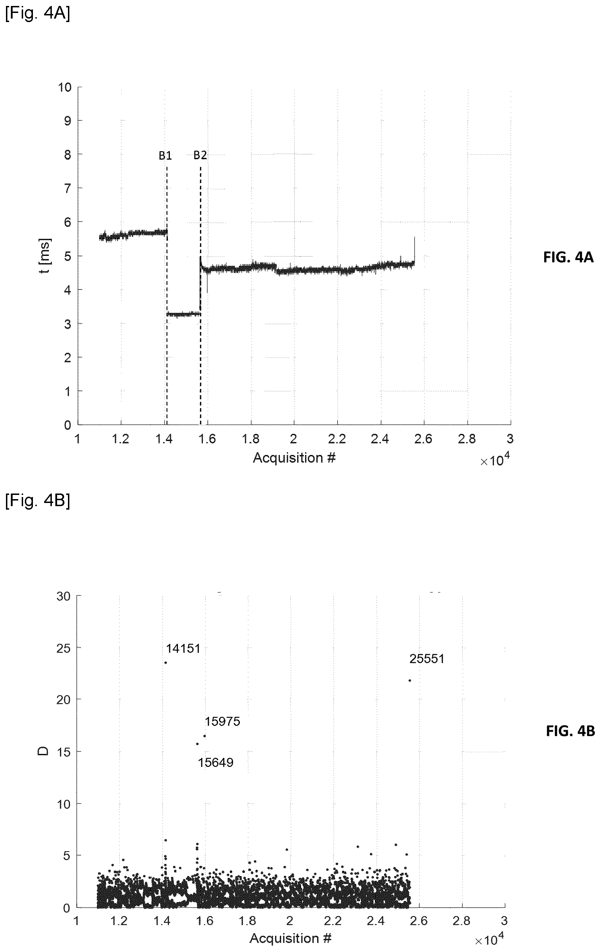

[Fig. 4A] est une représentation de plusieurs acquisitions de mesure du temps nécessaire à un élément mobile pour parcourir entre 25% et 75% de sa course de déplacement lors d'un passage du module de coupure d'une position fermée vers une position ouverte.

**Fig. 4B**

[Fig. 4B] est une représentation d'un score permettant de comparer chaque mesure de la [Fig. 4A] avec un premier ensemble comprenant les 50 mesures précédentes.

**Fig. 4C**

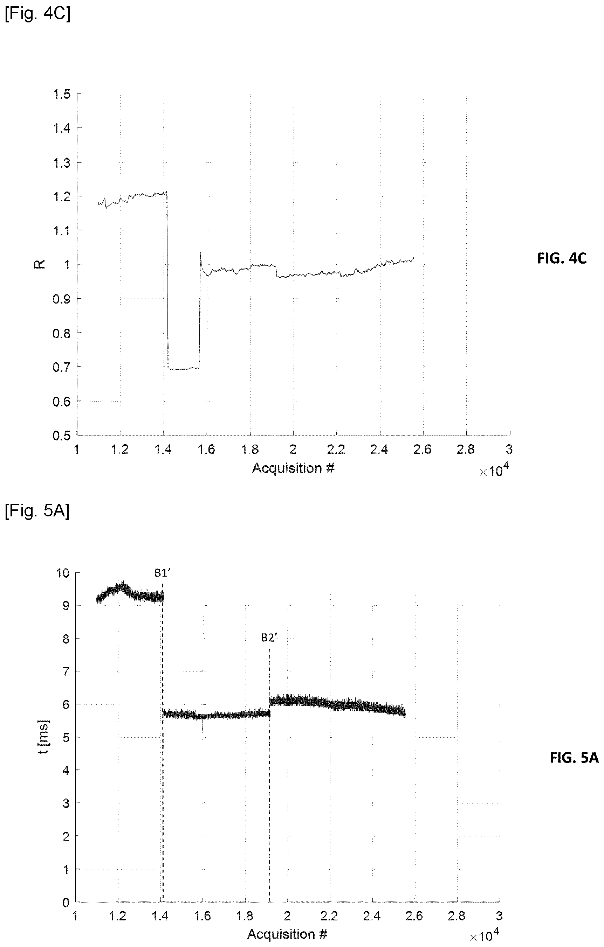

[Fig. 4C] est une représentation du ratio permettant de comparer chaque mesure de la [Fig. 4A] avec un second ensemble comprenant les 50 premières mesures.

**Fig. 5A**

[Fig. 5A] est une représentation de plusieurs acquisitions de mesure du temps nécessaire à un élément mobile pour parcourir entre 25% et 75% de sa course de déplacement lors d'un passage du module de coupure de la position ouverte vers la position fermée.

**Fig. 5B**

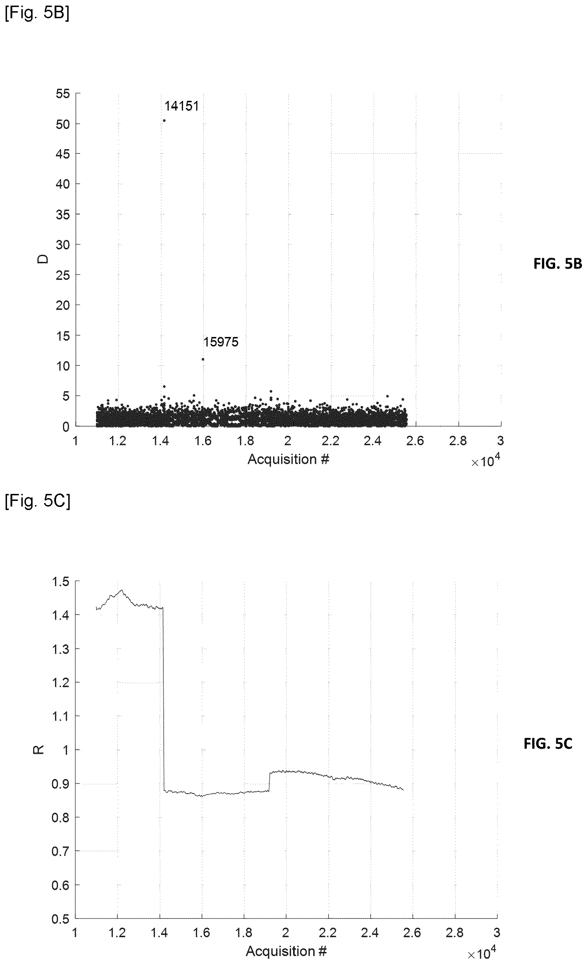

[Fig. 5B] est une représentation du score permettant de comparer chaque mesure de la [Fig. 5A] avec un premier ensemble comprenant les 50 mesures précédentes.

**Fig. 5C**

[Fig. 5C] est une représentation du ratio permettant de comparer chaque mesure de la [Fig. 5A] avec un second ensemble comprenant 50 acquisitions de mesures.

**Description des modes de réalisation**

Les dessins et la description ci-après contiennent, pour l'essentiel, des éléments de caractère certain. Ils pourront donc non seulement servir à mieux faire comprendre la présente divulgation, mais aussi contribuer à sa définition, le cas échéant.

**Appareil de coupure**

La [Fig. 1] illustre un module de coupure 1 d'un appareil de coupure selon un mode de réalisation particulier de l'invention, illustrant également le document FR2807204.

Bien que décrite dans le contexte d'un appareil de coupure particulier, l'invention ne doit toutefois pas être limitée à cet aspect. En particulier, tout autre architecture d'appareil de coupure est envisageable. L'appareil de coupure peut être choisi parmi un interrupteur, un disjoncteur, un contacteur, un interrupteur fusible et un réenclencheur automatique.

L'invention est plus particulièrement adaptée aux appareils de coupure moyenne tension et/ou haute tension. Dans le présent document, les termes « moyenne tension » et « haute tension » sont utilisés dans leur acceptation habituelle, à savoir que le terme « moyenne tension » désigne une tension qui est supérieure à 1 000 volts en courant alternatif et à 1 500 volts en courant continu mais qui ne dépasse pas 52 000 volts en courant alternatif et 75 000 volts en courant continu, tandis que le terme « haute tension » désigne une tension qui est strictement supérieure à 52 000 volts en courant alternatif et à 75 000 volts en courant continu.

L'appareil de coupure, tel qu'illustré de façon non-limitative par la [Fig. 1], comprend un mécanisme d'entraînement (non illustré) ainsi que le module de coupure 1. Le mécanisme d'entraînement peut être de tout type connu, comprenant notamment un arbre des pôles 7. Il peut s'agir par exemple d'un mécanisme du type décrit dans le document EP 0222645, EP 0789380 ou EP 1347479, muni d'un sous-ensemble d'armement et de fermeture comportant un ressort de fermeture et d'un sous-ensemble d'ouverture comportant un ressort d'ouverture.

En référence à la [Fig. 1], le module de coupure 1 comprend également classiquement une ampoule à vide 2 formant une enceinte qui renferme un contact fixe 3 et un contact mobile 4.

Le contact mobile 4 est configuré pour être déplacé par rapport au contact fixe de sorte que le module de coupure 1 peut se trouver alternativement dans une position ouverte, dans laquelle les contacts 3, 4 sont éloignés l'un de l'autre, et dans une position fermée, dans laquelle les contacts 3, 4 sont en contact l'un avec l'autre.

A l'extérieur de l'ampoule à vide 2, le contact mobile 4 est relié à un levier 5, par l'intermédiaire d'un bras isolant 6.

En fonctionnement, lorsque les contacts 3,4 sont en position ouverte, le ressort de fermeture entraine l'arbre des pôles 7 dans le sens inverse des aiguilles d'une montre. Le mouvement est transmis, notamment par une bielle 8 telle qu'illustrée sur la [Fig. 1], au levier 5 qui pivote dans le sens des aiguilles d'une montre et qui comprime un ressort 9. L'effort de fermeture est ensuite transmis par le ressort 9 au contact mobile 4.

Lorsque les contacts 3, 4 sont en position fermée, un ressort d'ouverture entraine l'arbre des pôles 7 dans le sens des aiguilles d'une montre. Le mouvement est transmis, notamment par la bielle 8 telle qu'illustrée sur la [Fig. 1], au levier 5 qui pivote dans le sens contraire des aiguilles d'une montre, entrainant le contact mobile 4 dans la position ouverte. La coupure d'un courant électrique passant par les contacts fixe et mobile 3, 4 est ainsi réalisée.

Cette chaîne cinématique permet ainsi de définir une pluralité d'axes géométriques de rotation permettant un mouvement pivotant de plusieurs éléments mobiles de l'appareil de coupure. Selon le mode de réalisation de la [Fig. 1], on obtient par exemple un premier axe géométrique 10 de pivotement de l'arbre des pôles 7, un deuxième axe géométrique 11 de pivotement du levier 5, un troisième axe géométrique 12 de pivotement de la bielle 8 par rapport aux manivelles de l'arbre des pôles 7, un quatrième axe géométrique 13 de pivotement de la bielle 8 par rapport au levier 5, et un cinquième axe géométrique 14 de pivotement de la partie isolante 6 par rapport au levier 5.

D'autres axes géométriques de rotation et d'autres éléments mobiles peuvent également exister dans la chaine cinématique de l'appareil de coupure pour le passage entre la position ouverte et la position fermée. Ces autres axes géométriques et autres éléments mobiles ne sont pas détaillés dans la suite.

Ainsi, l'appareil de coupure comprend une pluralité d'éléments mobiles pivotant autour d'axes géométriques de rotation lors de son fonctionnement.

L'invention porte sur un procédé de détection d'un état de fonctionnement de l'appareil de coupure à partir du temps de déplacement d'un ou plusieurs de ces éléments mobiles.

**Procédé de détection**

Le procédé vise à détecter un état de l'appareil de coupure à partir de mesures de temps acquises relativement à un élément mobile de l'appareil de coupure. Il est ainsi possible de connaitre les performances mécaniques de l'appareil de coupure et d'en déduire un diagnostic relatif à son fonctionnement.

L'élément mobile peut être avantageusement choisi pour être le levier 5 tel que décrit précédemment. Toutefois, les mesures peuvent être acquises concernant tout autre élément mobile de l'appareil de coupure, notamment tel que décrit ci-dessus.

La [Fig. 2] illustre la course de déplacement en rotation, avantageusement continu, de l'élément mobile lorsque le module de coupure passe entre la position fermée et la position ouverte. Dans la position fermée, l'élément mobile se trouve dans une première position, correspondant à 0% de sa course de déplacement. Dans la position ouverte, l'élément mobile se trouve dans une seconde position, correspondant à 100% de sa course de déplacement. La course de déplacement peut être mesurée sous la forme d'un angle de rotation ou d'une distance entre la position ouverte et la position fermée.

Entre la première position et la seconde position, l'élément mobile passe par des positions intermédiaires, par exemple illustrées sur la [Fig. 2] par des positions correspondant respectivement à 25%, 50% et 75% de la course de déplacement.

Les mesures de temps acquises selon le procédé correspondent avantageusement au passage de l'élément mobile entre deux positions intermédiaires. Les positions intermédiaires peuvent avantageusement être choisies dans une plage de valeurs de course de déplacement comprise entre 20% et 80%, voire encore plus particulièrement choisies entre 25% et 75 %.

Le choix de telles plages de valeurs permet de s'affranchir des éventuelles instabilités observées proches des valeurs limites 0% et 100% de la course de déplacement qui sont moins représentatives de l'état de l'appareil de coupure car davantage sensibles aux frottements divers, aux modes de déclenchement et aux rebonds inhérents au passage du module de coupure dans les positions ouverte et fermée.

A partir des mesures de temps acquises, le procédé permet de réaliser une analyse statistique pour détecter une pluralité d'états de l'appareil de coupure.

L'analyse statistique est avantageusement réalisée en fonction de valeurs relatives, obtenues par comparaison entre elles de mesures ou d'ensembles de mesures acquis à des instants différents avec le même appareil de coupure. Cela permet ainsi de limiter la prise en compte de facteurs extérieurs difficilement prévisibles, tels que la température ou l'apparition de vibrations mécaniques, susceptibles d'influencer sinon les mesures.

Un premier état de l'appareil de coupure est qualifié d'état indisponible. Dans cet état indisponible, l'appareil de coupure ne peut plus fonctionner correctement. En particulier, le passage du module de coupure de la position ouverte à la position fermée, ou inversement, est susceptible de ne pas être assuré à une vitesse adaptée, voire de ne plus être assuré du tout.

Un état indisponible se caractérise par un changement brusque des performances mécaniques, et notamment du temps de déplacement, d'un élément mobile de l'appareil de coupure.

Un état indisponible peut être dû à un mauvais fonctionnement d'un élément de l'appareil de coupure, notamment du module de coupure ou du mécanisme d'entraînement, par exemple à cause d'une fuite au niveau du fluide de coupure (huile, vide, etc.) ou d'une casse d'un élément. Dans certains cas, la détection d'un état indisponible entraine une interdiction d'utilisation de l'appareil de coupure jusque sa réparation ou son remplacement.

Un second état de l'appareil de coupure est qualifié d'état dégradé. Dans cet état dégradé, l'appareil de coupure peut toujours fonctionner mais moins efficacement qu'auparavant. En particulier, le passage du module de coupure de la position ouverte à la position fermée, ou inversement, est susceptible d'être réalisé à une vitesse moins adaptée.

Un état dégradé se caractérise par un changement graduel dans le temps des performances mécaniques, et notamment du temps de déplacement, d'un élément mobile de l'appareil de coupure.

Un état dégradé peut être dû à une usure ou un vieillissement d'un élément de l'appareil de coupure, notamment du module de coupure ou du mécanisme d'entraînement, par exemple un avachissement des ressorts du mécanisme d'actionnement, une augmentation des frottements mécaniques de la chaine cinématique des différents éléments mobiles dans l'appareil de coupure, ou une augmentation du couple résistant sur le levier de l'appareil de coupure. La détection d'un état dégradé permet d'intervenir suffisamment en amont sur l'appareil de coupure afin d'éviter par la suite une défaillance grave et potentiellement critique.

Le procédé peut éventuellement détecter d'autres états de l'appareil de coupure, non décrits par la suite.

On décrit ci-après les étapes du procédé de détection selon l'invention en lien avec la [Fig. 3]. Le procédé est réitéré lors de plusieurs itérations successives. Chaque itération correspond à un passage du module de coupure entre la position fermée et la position ouverte. Une itération correspond ainsi à une utilisation en condition réelle de l'appareil de coupure, c'est à dire lors de son fonctionnement sur une ligne d'alimentation électrique.

Plus particulièrement, la [Fig. 3] est décrite pour une itération d'indice k, k étant un entier supérieur ou égal à 2.

L'appareil de coupure est tout d'abord prêt au fonctionnement, le module de coupure étant généralement soit dans la position fermée, soit dans la position ouverte.

Dans une étape 101, le module de coupure passe dans l'autre des positions ouverte ou fermée, en particulier pour couper ou rétablir le courant électrique sur la ligne d'alimentation électrique.

On acquiert ainsi, lors d'une étape 102, au moins une mesure indicative d'un déplacement de l'élément mobile entre la première position et la seconde position.

La mesure peut notamment être acquise au moyen d'un capteur de rotation 15, illustré schématiquement sur la [Fig. 1], tel qu'un capteur mécanique, capacitif, inductif, résistif ou autres, configuré pour obtenir une mesure indicative du déplacement de l'élément mobile.

La mesure peut être une grandeur de temps, de vitesse ou tout autre grandeur qui mesure le rapport d'une évolution au temps.

Lors d'une étape 103, on compare au moins la mesure acquise d'itération d'indice k avec un premier ensemble E1 de mesures acquises lors des itérations précédentes 1 à k-1. En variante, il est également possible de comparer un ensemble de mesures, comprenant notamment la mesure d'itération d'indice k, avec le premier ensemble E1.

Avantageusement, le premier ensemble E1 dépend de l'itération k. En particulier, le premier ensemble E1 comprend, ou consiste en, des mesures qui varient en fonction de l'itération k considérée.

La comparaison peut être effectuée de différentes façons. Selon une réalisation, le premier ensemble E1 peut comprendre, avantageusement uniquement, des mesures acquises entre les itérations k-L et k-1, L étant un entier supérieur ou égal à 1. A titre d'exemple, L peut être égal à 50, le premier ensemble E1 comprenant alors l'ensemble des mesures acquises lors de 50 itérations précédant l'itération d'indice k. Bien entendu, d'autres premiers ensembles sont possibles comprenant des mesures acquises à des instants plus ou moins éloignés de la mesure d'itération d'indice k.

Selon une réalisation, la comparaison avec le premier ensemble E1 est réalisé à l'aide d'un score D, également appelé « score z » ou « score standard ». Un tel score D permet d'exprimer, en nombre d'écart-type, la distance entre la mesure acquise d'itération d'indice k et la moyenne des mesures du premier ensemble E1.

Plus particulièrement, le score D met en œuvre le test de Chauvenet, qui permet de déterminer si la mesure acquise $x[k]$ d'itération d'indice k peut être considérée comme une mesure aberrante ou non par rapport aux autres mesures précédentes du premier ensemble E1. Le score D peut être calculé selon la formule suivante :

[Math. 3]

$$D[k] = \frac{|X[k] - \bar{X}_L[k]|}{\sigma_L[k]}$$

Avec :

[Math. 4]

$$\bar{X}_L[k] = {\sum_{n=1}^{L} x[k-n]} \Big/ L$$

[Math. 5]

$$\sigma_L[k] = \sqrt{{\sum_{n=1}^{L}(x[k-n] - \bar{X}_L[k])^2} \Big/ {L-1}}$$

Lors d'une étape 104, on compare le score D calculé avec une première valeur seuil S1.

Si le score D est supérieur à la première valeur seuil S1, une alarme est générée à une étape 105 pour prévenir que l'appareil de coupure se trouve dans l'état indisponible tel que décrit ci-avant. En effet, cela signifie que la mesure d'itération d'indice k est particulièrement éloigné des mesures comprises dans le premier ensemble E1, de sorte qu'un changement récent dans l'appareil de coupure est venu dégrader son fonctionnement.

Si le score est inférieur à la première valeur seuil S1, à une étape 106, on compare au moins la mesure acquise à l'itération d'indice k avec un second ensemble E2 de mesures acquises lors des itérations précédentes 1 à k-1. Il est également possible de comparer un ensemble de mesures, comprenant notamment la mesure d'itération d'indice k, avec le second ensemble E2.

Selon une réalisation, le second ensemble E2 peut comprendre, avantageusement uniquement, des mesures acquises entre les itérations N et N+M-1, N et M étant des entiers supérieurs ou égaux à 1. A titre d'exemple, N peut être égal à 1 et M peut être égal à 50, le second ensemble E2 comprenant alors l'ensemble des 50 première mesures acquises. Le second ensemble E2 peut ainsi comprendre les valeurs testées chez le fabricant de l'appareil de coupure (aussi appelé valeurs de sortie d'usine). Bien entendu, comme pour le premier ensemble E1, d'autres seconds ensembles sont possibles comprenant des mesures acquises à des instants plus ou moins éloignées de la mesure d'itération d'indice k.

Avantageusement, le second ensemble E2 comprend donc des mesures qui ne dépendent pas de l'itération k considérée. Comparé au premier ensemble E1, le second ensemble E2 comprend ainsi des mesures fixes ou acquises lors d'itérations relativement plus éloignées de la mesure d'itération d'indice k.

La comparaison peut être effectuée de différentes façons. Selon une réalisation, la comparaison avec le second ensemble E2 est réalisée à l'aide d'un ratio R. Le ratio R exprime la différence relative entre la moyenne de l'ensemble des mesures acquises lors des M itérations précédant l'itération x[k] d'indice k et la moyenne des mesures du second ensemble E2.

Plus particulièrement, le ratio R est calculé selon la formule suivante :

[Math. 6]

$$R[k] = \frac{\bar{X}_M[k]}{\bar{X}_{M_{ref}}}$$

Avec :

[Math. 7]

$$\bar{X}_M[k] = \left.\sum_{n=0}^{M-1} x[k-n]\right/M$$

[Math. 8]

$$\bar{X}_{M_{ref}} = \left.\sum_{n=N}^{N+M-1} x[n]\right/M$$

Lors d'une étape 107, on compare le ratio R calculé avec une seconde valeur seuil S2.

Si le ratio R est supérieur à la seconde valeur seuil S2, une alarme est générée à une étape 108 pour prévenir que l'appareil de coupure se trouve dans l'état dégradé tel que décrit ci-avant. En effet, cela signifie qu'on assiste à une dérive progressive des mesures par rapport aux mesures du second ensemble E2, de sorte que cette dérive pourrait s'avérer préjudiciable au fonctionnement de l'appareil de coupure.

Si le ratio R est inférieur à la seconde valeur seuil S2, aucune alarme n'est générée.

Enfin, dans une étape 109, on mémorise la mesure d'itération d'indice k. A cet effet, l'appareil de coupure peut comprendre une mémoire ou transmettre les mesures acquises pour stockage sur un serveur distant (non illustré).

Le procédé peut ensuite être répété pour une itération d'indice k+1 lorsque l'appareil de coupure est de nouveau prêt au fonctionnement.

**Résultats expérimentaux**

Les figures [Fig. 4A], [Fig. 4B] et [Fig. 4C] illustrent la mise en œuvre du procédé de détection selon un premier mode de réalisation.

Sur la [Fig. 4A], on observe des mesures acquises selon ce premier mode de réalisation. Chaque mesure correspond au temps nécessaire à l'élément mobile pour parcourir une course de déplacement entre les positions intermédiaires de 25% et 75% lors d'un passage de la première position vers la seconde position (correspondant à un passage du module de coupure de la position fermée vers la position ouverte).

Les mesures sont représentées pour le module de coupure d'une phase du courant électrique. Toutefois, les résultats obtenus à partir de ces mesures sont transposables aux modules de coupure des autres phases du courant électrique.

Les décrochages brusques, illustrés sur la [Fig. 4A] par les lignes B1 et B2, correspondent à des opérations de maintenance ou de remplacement d'éléments effectuées réellement sur l'appareil de coupure, ayant entrainées une modification des caractéristiques de coupure et donc des mesures qui suivent. Ces décrochages ne doivent donc pas être pris en compte dans le procédé selon l'invention.

En particulier, après un décrochage brusque, les mesures des premier et second ensembles E1, E2, qui permettent la comparaison avec les mesures acquises par la suite, sont réinitialisées pour définir de nouvelles valeurs de référence.

[Fig. 4B] est une représentation du score D obtenu selon le test de Chauvenet décrit ci-avant, permettant de comparer chaque mesure de la [Fig. 4A] avec un premier ensemble E1 comprenant les 50 itérations précédant directement ladite mesure.

On observe sur cette [Fig. 4B] que certaines mesures (notamment les mesures 14151, 15649, 15975 et 25551) obtiennent un score D élevé, supérieur à 15, voire supérieur à 20. Ces mesures sont donc susceptibles de dépasser un seuil prédéterminé dépendant notamment de l'appareil de coupure considéré, et caractériser ainsi un état indisponible de l'appareil de coupure.

[Fig. 4C] est une représentation du ratio R obtenu tel que décrit ci-avant, permettant de comparer chaque mesure de la [Fig. 4A] avec un second ensemble E2 comprenant les 50 premières mesures acquises sur l'appareil de coupure.

On observe sur cette [Fig. 4C] que certaines mesures obtiennent un ratio R inférieur à 1 (correspondant à une vitesse de déplacement relativement plus rapide par rapport au second ensemble E2) ou un ratio R supérieur à 1 (correspondant à une vitesse de déplacement relativement plus lente). Ces mesures sont donc susceptibles de dépasser un seuil prédéterminé dépendant notamment de l'appareil de coupure considéré, et caractériser ainsi un état dégradé de l'appareil de coupure lié à une vitesse de fermeture/ouverture inadaptée du module de coupure.

De façon générale, et en dehors de tout décrochage ou changement brutal, on observe que le ratio R a tendance à augmenter au cours du temps traduisant une usure et un vieillissement graduel de l'appareil de coupure susceptible de le conduire à un état dégradé.

Les figures [Fig. 5A], [Fig. 5B] et [Fig. 5C] illustrent la mise en œuvre du procédé de détection selon un second mode de réalisation.

Sur la [Fig. 5A], on observe des mesures acquises selon ce second mode de réalisation. Chaque mesure correspond au temps nécessaire à l'élément mobile pour parcourir une course de déplacement entre les positions intermédiaires de 25% et 75% lors d'un passage de la seconde position vers la première position (correspondant à un passage du module de coupure de la position ouverte vers la position fermée).

Les mesures sont représentées pour le module de coupure d'une phase du courant électrique. Toutefois, les résultats obtenus à partir de ces mesures sont transposables aux modules de coupure des autres phases du courant électrique.

De la même façon que pour la [Fig. 4A], les décrochages brusques, illustrés sur la [Fig. 5A] par les lignes B1' et B2' correspondent à des opérations de maintenance ou de remplacement d'éléments effectuées réellement sur l'appareil de coupure, ayant entraînées une modification des caractéristiques de coupure et donc des mesures suivantes. Ces décrochages ne doivent donc pas être pris en compte dans le procédé selon l'invention.

[Fig. 5B] est une représentation du score D obtenu selon le test de Chauvenet décrit ci-avant, permettant de comparer une mesure de la [Fig. 5A] avec un premier ensemble E1 comprenant les 50 itérations précédant directement ladite mesure.

On observe sur cette [Fig. 5B] que certaines acquisitions (notamment les mesures 14151 et 15975) obtiennent un score D élevé, supérieur à 10, voire supérieur à 50. Ces mesures sont donc susceptibles de dépasser un seuil prédéterminé et caractériser ainsi un état indisponible de l'appareil de coupure.

[Fig. 5C] est une représentation du ratio R obtenu tel que décrit ci-avant, permettant de comparer chaque mesure de la [Fig. 5A] avec un second ensemble E2 comprenant les 50 premières mesures acquises de l'appareil de coupure.

On observe sur cette [Fig. 5C] que certaines acquisitions obtiennent un ratio R inférieur à 1 (correspondant à une vitesse de déplacement plus rapide) ou un ratio R supérieur à 1 (correspondant à une vitesse de déplacement plus lent). Ces mesures sont donc susceptibles de dépasser un seuil prédéterminé, et caractériser ainsi un état dégradé de l'appareil de coupure lié à une vitesse de fermeture/ouverture inadaptée du module de coupure.

Bien évidemment, l'invention n'est pas limitée aux modes de réalisation décrits précédemment et fournis uniquement à titre d'exemple. Elle englobe diverses modifications, formes alternatives et autres variantes que pourra envisager l'homme du métier dans le cadre de la présente invention et notamment toutes combinaisons des différents modes de fonctionnement décrits précédemment, pouvant être pris séparément ou en association.

En particulier, bien que les comparaisons aient été avantageusement illustrées ci-dessus par l'utilisation d'un score D et d'un ratio R particuliers pour déterminer l'état de l'appareil de coupure, d'autres méthodes de comparaison mettant également en œuvre un rapport ou une relation d'ordre entre des mesures indicatives d'un déplacement de l'élément mobile sont envisageables.

Enfin, le procédé est décrit ci-dessus uniquement pour la détection de deux états, indisponible ou dégradé. Toutefois, ce procédé pourrait être avantageusement généralisé à d'autres états caractérisant le fonctionnement et/ou l'état mécanique d'un appareil de coupure.

**Revendications**

1. Procédé de détection d'un état d'un appareil de coupure, l'appareil de coupure comprenant un élément mobile (5) entre une première position et une seconde position, le procédé comprenant les étapes suivantes, pour une itération d'indice k supérieur ou égal à 2 :

   a) Acquérir au moins une mesure indicative d'un déplacement de l'élément mobile (5) entre la première position et la seconde position à l'itération d'indice k ;
   b) Comparer au moins la mesure acquise à l'itération donnée k avec un premier ensemble (E1) de mesures acquises lors des itérations précédentes 1 à k-1, le premier ensemble (E1) comprenant les mesures acquises entre les itérations k-L et k-1, L étant un entier supérieur ou égal à 1 ;
   c) Générer une première alarme en fonction de la comparaison obtenue à l'étape b) pour indiquer que l'appareil de coupure est dans un état indisponible ;
   d) Comparer au moins la mesure acquise à l'itération donnée k avec un second ensemble (E2) de mesures acquises lors des itérations précédentes 1 à k-1, le second ensemble (E2) comprenant les mesures acquises entre les itérations N et N+M-1, N et M étant des entiers supérieurs ou égaux à 1 ; et
   e) Générer une seconde alarme en fonction de la comparaison obtenue à l'étape d) pour indiquer que l'appareil de coupure est dans un état dégradé.

**2.** Procédé selon la revendication 1, dans lequel la comparaison obtenue à l'étape b) est effectuée par application du critère de Chauvenet.

**3.** Procédé selon l'une quelconque des revendication précédentes, dans lequel la comparaison obtenue à l'étape b) est effectuée à partir d'un score D selon la formule suivante :

$$D[k] = \frac{|X[k] - \bar{X}_L[k]|}{\sigma_L[k]}$$

Avec :

$$\bar{X}_L[k] = \left.\sum_{n=1}^{L} x[k-n]\right/_L$$

$$\sigma_L[k] = \sqrt{\left.\sum_{n=1}^{L}(x[k-n] - \bar{X}_L[k])^2\right/_{L-1}}$$

**4.** Procédé selon l'une quelconque des revendication précédentes, dans lequel la comparaison obtenue à l'étape d) est effectuée à partir d'un ratio R selon la formule suivante :

$$R[k] = \frac{\bar{X}_M[k]}{\bar{X}_{M_{ref}}}$$

Avec :

$$\bar{X}_M[k] = \left.\sum_{n=0}^{M-1} x[k-n]\right/_M$$

$$\bar{X}_{M_{ref}} = \left.\sum_{n=N}^{N+M-1} x[n]\right/_M$$

**5.** Procédé selon l'une quelconque des revendications précédentes, dans lequel la première alarme et/ou la seconde alarme sont générés lorsque les comparaisons obtenues à l'étape b) et/ou à l'étape d) sont supérieures à une valeur seuil (S1, S2).

**6.** Procédé selon l'une quelconque des revendications précédentes, dans lequel la mesure correspond à une plage de rotation comprise entre 20 % et 80 % d'une course de déplacement de l'élément mobile (5) entre la première position et la seconde position.

**7.** Procédé selon l'une quelconque des revendications précédentes, dans lequel la mesure est égale à la durée du déplacement de l'élément mobile (5) entre deux positions intermédiaires comprises entre la position ouverte et la position fermée.

**8.** Procédé selon l'une quelconque des revendications précédentes, comprenant une étape supplémentaire :
f) Mémoriser la mesure d'itération d'indice k acquise à l'étape a).

**9.** Procédé selon l'une quelconque des revendications précédentes, dans lequel la mesure acquise correspond à un passage en condition réelle d'un module de coupure entre une position ouverte et une position fermée.

**10.** Appareil de coupure mettant en œuvre le procédé selon l'une quelconque des revendications précédentes.

**11.** Appareil de coupure selon la revendication 10, dans lequel l'élément mobile (5) est un levier rotatif principal.

[Fig. 1]

FIG. 1

[Fig. 2]

FIG. 2

[Fig. 3]

FIG. 3

[Fig. 4A]

FIG. 4A

[Fig. 4B]

FIG. 4B

[Fig. 4C]

FIG. 4C

[Fig. 5A]

FIG. 5A

[Fig. 5B]

FIG. 5B

[Fig. 5C]

FIG. 5C

Europäisches Patentamt

European Patent Office

Office européen des brevets

## RAPPORT DE RECHERCHE EUROPEENNE

Numéro de la demande

EP 20 19 1082

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | DE 195 04 714 A1 (DAIMLER BENZ AG [DE]; LICENTIA GMBH [DE]) 22 août 1996 (1996-08-22) | 1-5,8, 10,11 | INV. H01H11/00 |
| A | * colonne 7, ligne 8 - colonne 8, ligne 13; revendications 2,3,4; figure 1 * * colonne 5, ligne 3 - colonne 5, ligne 60 * | 6,7,9 | ADD. H01H33/666 |
| | ----- | | |
| X | DE 196 04 203 A1 (ABB PATENT GMBH [DE]) 7 août 1997 (1997-08-07) | 1-7,9,10 | |
| A | * colonne 3, ligne 39 - colonne 4, ligne 50; revendications 1-3; figures 1-4 * * colonne 2, ligne 26 - colonne 2, ligne 53 * | 8,11 | |
| | ----- | | |
| X | EP 2 405 454 A1 (SCHNEIDER ELECTRIC SACHSENWERK [DE]) 11 janvier 2012 (2012-01-11) * alinéa [0039] - alinéa [0042]; revendications 4-6; figures 1,2 * * alinéa [0060] * | 1-11 | |
| | ----- | | DOMAINES TECHNIQUES RECHERCHES (IPC) H01H |

Le présent rapport a été établi pour toutes les revendications

| Lieu de la recherche | Date d'achèvement de la recherche | Examinateur |
|---|---|---|
| Munich | 14 janvier 2021 | Ernst, Uwe |

EPO FORM 1503 03.82 (P04C02)

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

**ANNEXE AU RAPPORT DE RECHERCHE EUROPEENNE
RELATIF A LA DEMANDE DE BREVET EUROPEEN NO.**

EP 20 19 1082

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

14-01-2021

| Document brevet cité au rapport de recherche | Date de publication | Membre(s) de la famille de brevet(s) | Date de publication |
|---|---|---|---|
| DE 19504714 A1 | 22-08-1996 | AUCUN | |
| DE 19604203 A1 | 07-08-1997 | AUCUN | |
| EP 2405454 A1 | 11-01-2012 | CN 102394190 A<br>DE 102010026528 A1<br>EP 2405454 A1 | 28-03-2012<br>12-01-2012<br>11-01-2012 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2807204
- EP 0222645 A
- EP 0789380 A
- EP 1347479 A